# EUROPEAN PATENT APPLICATION

(11) **EP 4 770 342 A2**
(43) Date of publication of application: **01.07.2026**
(21) Application number: 25224131.0
(22) Date of filing: 16.12.2025
(51) Int. Cl.: H10F 19/85, H10F 19/90

(54) **PHOTOVOLTAIC MODULE WITH SUBSTRATE**

(30) Priority: 24.12.2024 IT 202400029943
(71) Applicant: 3SUN S.r.l., 95121 Catania (CT) (IT)
(72) Inventor: Gerardi, Cosimo, 95121 Catania (CT) (IT); Ragonesi, Antonino, 95121 Catania (CT) (IT); Scuto, Andrea, 95121 Catania (CT) (IT); Fucile, Alessandro, 95121 Catania (CT) (IT); Digeronimo, Giulia, 95121 Catania (CT) (IT)
(74) Representative: Petraz, Gilberto Luigi

(57) **Abstract**

A photovoltaic module (300) is described comprising:
- a substrate (320) for mechanical support and electrical connection comprising a sheet (322) of electrically insulating plastic material and at least one layer (324) of electrically conducting metallic material suitably configured, said substrate (320) being located on the back of the photovoltaic module (300);
- a plurality of photovoltaic cells (310) mechanically fixed to the substrate (320) and electrically connected to each other through the layer (324) of the substrate (320) so as to form one or more strings of cells, said cells (310) being located on the front side of the photovoltaic module (200) adjacent to each other and adjacent to the substrate (320);

the layer (324) is configured such that adjacent cells of said plurality of cells (310) are electrically connected two by two;
the photovoltaic module further comprises a plurality of bypass diodes electrically connected to the cells (310).

## Description

### FIELD OF THE INVENTION

The present invention generally relates to a photovoltaic module comprising a substrate and a plurality of photovoltaic cells supported by the substrate and electrically connected through the substrate.

### STATE OF THE ART

As is known, the cells of a photovoltaic module are connected in series with each other to generally form a string.

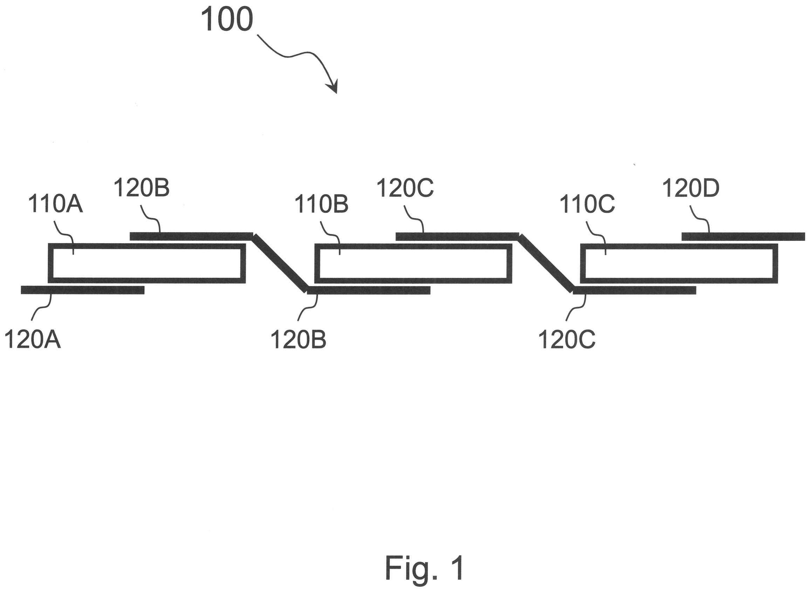

Fig. 1 schematically shows an example of a photovoltaic module 100 comprising three photovoltaic cells 110A, 110B, 110C electrically connected in series with each other so as to form a single string. In the module 100, there are electrical connections 120A, 120B, 120C, 120D; in general, these connections are made by means of a "ribbon". The first connection 120A serves to make a first pole of the string available outside the module 100, for example the positive pole. The last connection 120D serves to make the other pole of the string, for example the negative pole, available outside the module 100. There are then intermediate connections 120B and 120C that serve to connect the cells to each other; in particular, each of them connects the front of a cell with the back of a cell next to it with a "Z" configuration.

Intermediate connections such as those shown schematically in Fig. 1 have several disadvantages. Their "Z" shape and their structure (in terms of constituent materials) means that the cells cannot be adjacent, but must be spaced apart. Furthermore, the "ribbons" and their connection entail high costs.

Furthermore, a module such as that shown schematically in Fig. 1 requires support components of the cells and an appropriate assembly procedure of the module.

US-A1-2017/179324, US-B2-12046690, US-A1-2017/018670 and US-B2-8704085 disclose known solutions of photovoltaic modules, but which do not fully solve the technical problems indicated above.

### SUMMARY OF THE INVENTION

The general object of the present invention is to improve the prior art.

The present invention is set forth and characterized in the independent claim. The dependent claims describe other characteristics of the present invention or variants to the main inventive idea.

In accordance with the aforesaid objects and to solve the technical problem in a new and original manner, also obtaining considerable advantages with respect to the state of the art, a photovoltaic module comprises a substrate for mechanical support and electrical connection comprising a sheet of electrically insulating material and at least one layer of electrically conducting material suitably configured, said substrate being located on the back of the photovoltaic module, a plurality of photovoltaic cells mechanically fixed to the substrate and electrically connected to each other through the layer of the substrate so as to form one or more strings of cells, said cells being located on the front side of the photovoltaic module adjacent to each other and adjacent to the substrate; wherein said layer is configured such that adjacent cells of said plurality of cells are electrically connected two by two.

Layer configured such that adjacent cells are electrically connected two by two means, for example, that the layer comprises a plurality of electrical connection areas adapted to connect a negative pole of a first cell with a positive pole of a cell adjacent to the first.

An essential aspect of the present invention is the presence of a plurality of bypass diodes in the photovoltaic module.

Specifically, they are electrically connected between adjacent cells. That is, the bypass diodes are provided for connecting the photovoltaic cells two by two. Advantageously, the photovoltaic cells are bifacial. More advantageously, the photovoltaic cells are arranged with alternating polarity with respect to each other. That is, each cell has its own poles oriented at the respective opposite pole of the adjacent cell or cells. For example, for each cell arranged with a frontally oriented positive pole and a posteriorly oriented negative pole with respect to the photovoltaic module, the adjacent cell(s) are arranged with a posteriorly oriented positive pole and a frontally oriented negative pole.

Bifacial means, within the scope of the present invention, that the two poles of the same cell are accessible on opposite faces thereof. For example, the positive pole is accessible on a first face of the cell and the negative pole is accessible on a second face of the cell, opposite the first face.

According to embodiments, the number of bypass diodes is equal to half the total number of said photovoltaic cells of the module.

In accordance with embodiments, the photovoltaic module further comprises a plurality of strips of electrically conductive material positioned so as to electrically connect adjacent cells two by two on the front of the photovoltaic module.

In other embodiments, one bypass diode may be provided for each photovoltaic cell, in such case the bypass diodes are connected in parallel to the photovoltaic cells.

### DESCRIPTION OF THE DRAWINGS

These and other aspects, characteristics and advantages of the present invention will become apparent from the following description of embodiments, given as a non-restrictive example with reference to the attached drawings wherein:
- Fig. 1 is a schematic side view of a photovoltaic module according to the known art;
- Fig. 2 is a schematic side view of a photovoltaic module (or rather part of a module) according to a first embodiment of the present invention;
- Fig. 3 is a schematic side view of a photovoltaic module (or rather part of a module) according to a second embodiment of the present invention; and
- Fig. 4 contains two schematic front views of the module of Fig. 3; Fig. 4A shows the photovoltaic cells placed on the substrate and Fig. 4B shows the substrate without cells.

We must clarify that in the present description the phraseology and terminology used, as well as the figures in the attached drawings also as described, have the sole function of better illustrating and explaining the present invention, their function being to provide a non-limiting example of the invention itself, since the scope of protection is defined by the claims.

To facilitate comprehension, the same reference numbers have been used, where possible, to identify identical common elements in the drawings. It is understood that elements and characteristics of one embodiment can be conveniently combined or incorporated into other embodiments without further clarifications.

### DESCRIPTION OF SOME EMBODIMENTS OF THE PRESENT INVENTION

A fundamental element underlying the present invention is the use of a substrate that acts as both a mechanical support and an electrical connection for the photovoltaic cells. Typically, there will be a single support for the entire module. The substrate comprising a sheet of electrically insulating material, e.g. plastic material, and at least one layer of electrically conductive material, e.g. metallic material; as clarified below, it is not excluded that there can be at least one further layer of electrically conductive material, e.g. metallic material. The layer is suitably configured to make at least the electrical connections between the photovoltaic cells. The layer is located on the back of the photovoltaic module.

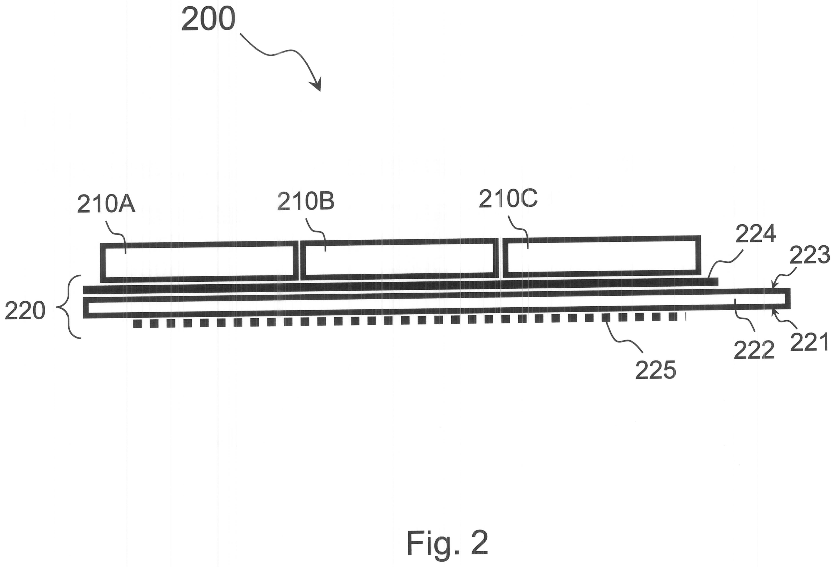

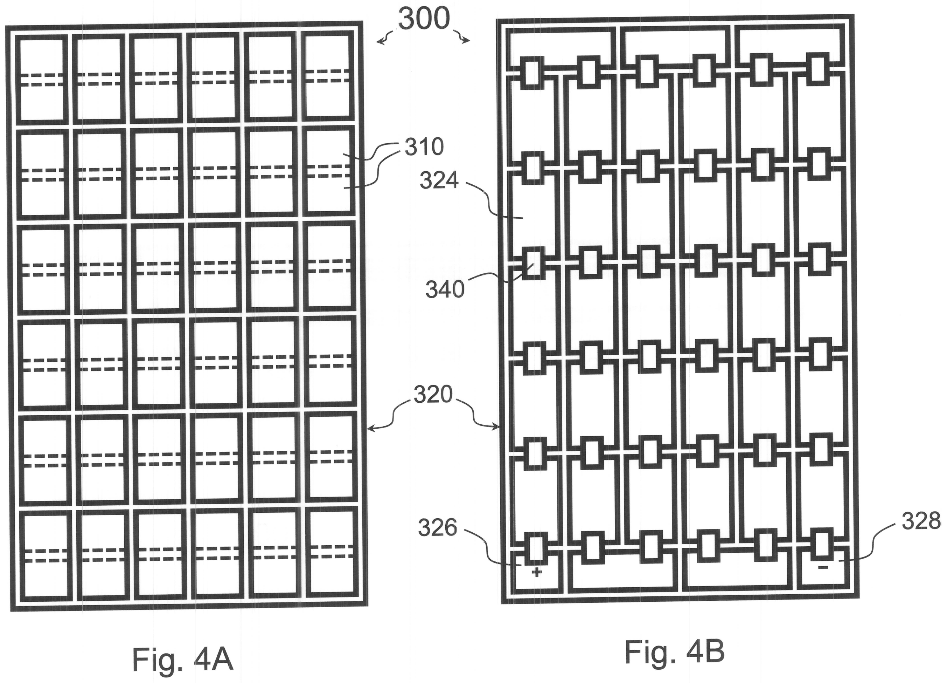

Fig. 2 shows an embodiment of a photovoltaic module 200 according to the present invention; to be precise, Fig. 2 shows only part of the module (for example the bypass diodes are not visible even if present - see Fig. 4). The substrate is indicated overall with reference numeral 220 and some photovoltaic cells are indicated with reference numeral 210. In particular,
210A is a first cell, 210B is a second cell and 210C is a third cell; such cells are adjacent to each other.

The substrate is indicated with reference numeral 222 and a first layer with reference numeral 224; a second layer is indicated with reference numeral 225 and is dashed because it is optional. The layer 224 is adjacent to the upper face 223 of the substrate 222 and the layer 225 is adjacent to the lower face 221 of the substrate 222.

Fig. 2 is schematic and illustrative. Spaces are therefore seen between the elements; however, the adjacency mentioned above implies that such elements are in contact. Regarding the cells, these are in contact laterally with each other and there are (small) components of electrically insulating material in the middle; alternatively, they can be slightly spaced apart from each other. In any case, the distance therebetween is much less than that separating the cells 110 in Fig. 1.

In Fig. 2, the cells 210 are rested on the layer 224 to make electrical connections as better clarified below. Means are provided which are adapted to keep the cells in mechanical and electrical contact with the layer below. Such means can be, for example, of a mechanical type. Alternatively or additionally, adhesive material can be provided.

In the example of Fig. 2, the electrical connections between the cells 210 are made only by means of a suitably configured layer 224. This is possible if the cells 210 are made in such a way that both their poles, i.e. the negative pole and the positive pole, are accessible on the same face of the cell.

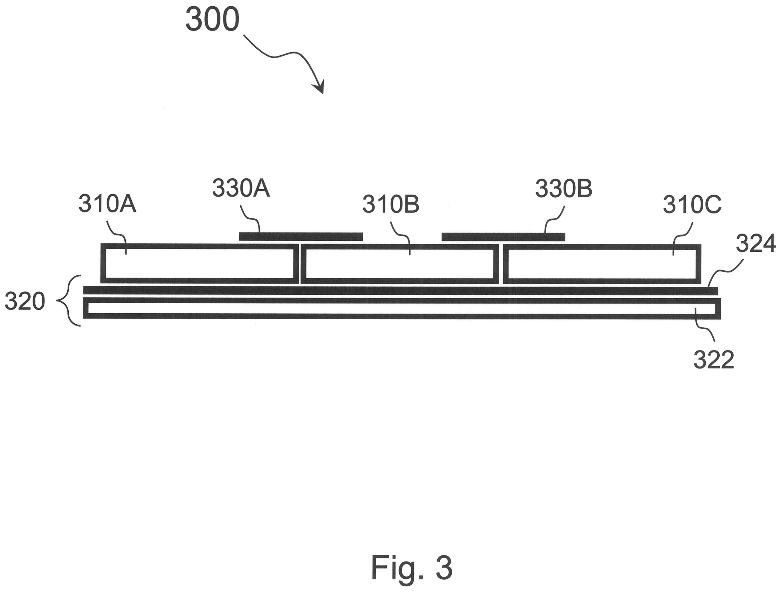

Fig. 3, on the other hand, shows a solution similar to that in Fig. 2, but in which the two poles of the cell are accessible on opposite faces of the cell. Therefore, a plurality of strips of electrically conductive material are used for the electrical connection between the cells; these, however, unlike the solution of Fig. 1, are arranged along a plane and do not have to be "Z" shaped and do not involve the need to move the cells apart from each other.

In Fig. 3, the photovoltaic module is indicated with 300, the photovoltaic cells are indicated with 310 (in particular three cells 310A, 310B, 310C), the substrate with 320, provided with a sheet 322 and at least one layer 324 (similar to the sheet 222 and the layer 224), and the strips are indicated with 330. According to the example of Fig. 3, the cells are oriented according to inverted polarities; for example, the cells 310A and 310C have the positive pole above and the negative pole below, while the cell 310B has the positive pole below and the negative pole above.

Both in the case of the module 200 and in the case of the module 300, the sheet can be of electrically insulating material, but also at least partially transparent; this is particularly advantageous if the cells are bifacial.

The photovoltaic cells of the photovoltaic module according to the present invention are advantageously bifacial. In particular, the cells 310 of the module 300 are bifacial; in particular, according to this embodiment, the cells are oriented according to inverted polarities, that is, a cell has the negative pole below (and the positive pole above), the cell next to it has the positive pole below (and the negative pole above), the cell further next to it has the negative pole below (and the positive pole above), and so on.

Fig. 4A and Fig. 4B allow a clear understanding of a possible arrangement and a possible configuration of the cells 310 and the layer 324, for example of Fig. 3 as well as the bypass diodes, indicated with reference number 340.

In Fig. 4A, the cells 310 (substantially square-shaped) are shown in pairs (substantially rectangular-shaped) with poles arranged in an inverted manner as mentioned above. They make a matrix arrangement formed by, for example, 6x12 cells on the underlying sheet 322 of the substrate 320.

Between the cells 310 and the sheet 322 of the substrate 320 is the suitably configured layer 324. Fig. 4B shows a possible configuration of the layer 324 which consists of a plurality of rectangles, or electrical connection areas, which serve to connect a negative pole with a positive pole of two adjacent cells. According to this embodiment, the rectangles are 6x5 + 3 + 2 = 35. The areas 326 and 328 correspond respectively to the positive pole and the negative pole of the module 300.

According to the example of Fig. 3, adjacent cells of the plurality of cells 310 are electrically connected two by two below by means of the layer 324 suitably configured and two by two above by means of the strips 330.

In the module 300 there are then for example 72 cells connected in series to form a single string.

To overcome the shading problem of the individual cells, a plurality of bypass diodes electrically connected to the cells have been provided; this is an essential aspect of the present invention. In particular, according to the example of Fig. 3 or similar examples, the bypass diodes can be electrically connected between adjacent cells, while, according to the example of Fig. 2 or similar examples, the bypass diodes can be electrically connected in parallel to the cells.

A high number of bypass diodes (see for example Fig. 4B) allows to totally overcome the shading problem of the photovoltaic module and therefore maximize its electricity production even when the cells are not irradiated in exactly the same way.

Preferably and very advantageously, such diodes are integrated in or on the substrate 320. Such diodes can be made by means of microelectronic technologies that make them particularly thin and could be of the same thickness as the layer 324; alternatively, slight recesses can be provided in the sheet 322 which adapted to house them.

Advantageously, according to a first possible alternative, the number of bypass diodes can be equal (or almost equal) to half the total number of photovoltaic cells of the module; for example, in Fig. 4, there are 72 cells and 36 diodes; such diodes can be electrically connected between adjacent cells.

Advantageously, according to a second possible alternative, the number of bypass diodes can be equal (or almost equal) to the total number of photovoltaic cells of the module; such diodes can be electrically connected in parallel to the cells.

According to a very important aspect of the present invention, the photovoltaic module is "smart". It can therefore perform functions in addition to the simple production of electricity by means of photovoltaic effect.

A first (simple) possibility is to provide one or more sensors, integrated in or on the substrate. For example, a temperature sensor can be provided that allows, for example, to more accurately evaluate the energy yield of the module.

More generally, electronic components can be provided, integrated in or on the substrate.

Such electronic components can be of various complexity and can range from a simple sensor to an electronic circuit comprising a processor and/or a transmitter. The transmitter can be of any type, e.g., wi-fi, bluetooth, conveyed waves, or the like. The electronic components can also comprise sensors, capacitors, inductors, transformers, inverters, microcontrollers, microinverters, security breakers, electronic switches, power optimizers, DC-DC converters and transmission hardware/software systems that can have different functions, for example ensuring the security of the transmitted data.

Such electronic components can be arranged on a first face of the substrate (e.g., the upper face or side near the photovoltaic cells), or on a second face or side of the substrate (e.g., the lower face away from the photovoltaic cells), or on both faces or sides.

For the connection of such electronic components, a first conductive layer (for example, that adjacent to the upper face or side of the sheet near the photovoltaic cells), or a second conductive layer (for example, that adjacent to the lower face or side of the sheet away from the photovoltaic cells), or both conductive layers can be used. Such conductive layers could also be electrically connected to each other.

Preferably, said electronic components are adapted to be connected with electronic circuitry external to the module; the connection can be of the "wired" or "wireless" type.

Advantageously, such electronic components are adapted to be electrically powered by one or more photovoltaic cells of the module itself. If the cell were adapted to generate in an output, for example, a voltage of 0.7 Vdc and the electronic components required a supply voltage, for example, of 5 or 12 Vdc, a step-up dc-dc converter with a 0.7 volt input could be used; such a converter could be integrated in the module. If, on the other hand, cells were used in pairs to power the electronic components, a converter with a 1.4-volt input could be used, for example.

In the embodiment of Fig. 3 and Fig. 4, the entire surface or almost the entire surface (e.g. 90%) of the module is occupied by photovoltaic cells; with reference to Fig. 4A, there are very small frames around the cells not covered by cells and a slightly larger frame at the outline of the module.

According to variants of such an example, it could be envisaged that there are larger areas not covered by cells; for example, an area corresponding to the area of a cell may not be covered by a cell. Such a non-covered area could for example house or support electronic components, for example that described above.

It is clear that modifications and/or additions of parts may be made to the photovoltaic module described heretofore, without departing from the field and scope of the present invention, as defined by the claims.

It is also clear that, although the present invention has been described with reference to some specific examples, a person of skill in the art shall certainly be able to achieve other equivalent forms of the photovoltaic module with substrate, the characteristics as set forth in the claims and hence all coming within the field of protection defined thereby.

In the following claims, the sole purpose of the references in brackets is to facilitate their reading and they must not be considered as restrictive factors with regard to the scope of protection defined by the claims.

## Claims

1. Photovoltaic module (300) comprising:
- a substrate (320) for mechanical support and electrical connection comprising a sheet (322) of electrically insulating material and at least one layer (324) of electrically conducting material suitably configured, said substrate (320) being located on the back of the photovoltaic module (300);
- a plurality of photovoltaic cells (310) mechanically fixed to the substrate (320) and electrically connected to each other through the layer (324) of the substrate (320) so as to form one or more strings of cells, said cells (310) being located on the front side of the photovoltaic module (300) adjacent to each other and adjacent to the substrate (320);
wherein said layer (324) is configured such that adjacent cells of said plurality of cells (310) are electrically connected two by two;
**characterised in that** it further comprises:
- a plurality of bypass diodes (340) electrically connected to the cells (310) so as to connect them two by two, **and that** said photovoltaic cells (210) are bifacial and with alternating polarities therebetween.

2. Photovoltaic module (300) according to claim 1, wherein each cell (310) is arranged with its poles oriented at the respective opposite pole of the adjacent cell or adjacent cells.

3. Photovoltaic module (300) according to claim 1 or 2, wherein a cell (310) is arranged with a frontally oriented positive pole and a posteriorly oriented negative pole with respect to said photovoltaic module (300), and the adjacent cell(s) are arranged with a posteriorly oriented positive pole and a frontally oriented negative pole.

4. Photovoltaic module (300) according to any one of the preceding claims, wherein the bypass diodes (340) are in or on the substrate (320).

5. Photovoltaic module (300) according to any one of the preceding claims, wherein the number of bypass diodes (340) is equal to half of the total number of said photovoltaic cells (310) of the module (300), and the diodes (340) are electrically connected between adjacent cells (310).

6. Photovoltaic module (300) according to any one of the preceding claims, further comprising:
- a plurality of strips (330A, 330B) of electrically conductive material positioned so as to electrically connect adjacent cells (310A, 310B, 310C) two by two on the front of the photovoltaic module (300).

7. Photovoltaic module (200) according to any one of the preceding claims, wherein said substrate comprises another layer (225) of electrically conductive material suitably configured, said layers (224, 225) of electrically conductive material being on opposite sides (221, 223) of the substrate (220).

8. Photovoltaic module according to any one of the preceding claims, further comprising:
- one or more sensors, in particular integrated in or on the substrate.

9. Photovoltaic module according to any one of the preceding claims, further comprising:
- electronic components, integrated in or on the substrate, and preferably adapted to be connected with electronic circuitry external to the module.

10. Photovoltaic module according to claim 9, wherein said electronic components comprises a processor and/or a transmitter.

11. Photovoltaic module according to claim 9 or 10, wherein said electronic components are adapted to be electrically powered by one or more photovoltaic cells of the module.
